# EUROPÄISCHE PATENTSCHRIFT

(11) **EP 3 172 772 B1**
(45) Veröffentlichungstag und Bekanntmachung des Hinweises auf die Patenterteilung: **02.09.2020**
(21) Anmeldenummer: 15738051.0
(22) Anmeldetag: 10.07.2015
(51) Int. Cl.: H01L 41/04, H01L 41/107, H05H 1/24

(54) **PIEZOELEKTRISCHER TRANSFORMATOR**
PIEZOELECTRIC TRANSFORMER
TRANSFORMATEUR PIEZOÉLECTRIQUE

(30) Priorität: 23.07.2014 DE 102014110405
(43) Veröffentlichungstag der Anmeldung: 31.05.2017
(73) Patentinhaber: TDK Electronics AG, 81671 München (DE)
(72) Erfinder: DÖLLGAST, Bernhard, A-8530 Deutschlandsberg (AT); PUFF, Markus, A-8010 Graz (AT); KUDELA, Pavol, A-8530 Deutschlandsberg (AT); WEILGUNI, Michael, A-4232 Hagenberg (AT)
(74) Vertreter: Epping - Hermann - Fischer
(86) Internationale Anmeldenummer: PCT/EP2015/065886
(87) Internationale Veröffentlichungsnummer: WO 2016/012282

(56) Entgegenhaltungen:
- WO-A2-2007/006298
- JP-A- H09 181 372
- JP-U- H0 652 161
- ANDREW BENWELL ET AL: "Flashover Prevention of High Voltage Piezoelectric Transformers by Thin Film Encapsulation", IEEE TRANSACTIONS ON PLASMA SCIENCE, IEEE SERVICE CENTER, PISCATAWAY, NJ, US, Bd. 38, Nr. 12, 1. Dezember 2010 (2010-12-01), Seiten 3455-3459, XP011338404, ISSN: 0093-3813, DOI: 10.1109/TPS.2010.2079957

## Beschreibung

Die vorliegende Erfindung betrifft einen piezoelektrischen Transformator. Der piezoelektrische Transformator kann insbesondere in einer Vorrichtung zur Erzeugung von Atmosphärendruck-Plasmen eingesetzt werden.

Ein piezoelektrischer Transformator ist eine Bauform eines Resonanztransformators, welcher auf Piezoelektrizität basiert und im Gegensatz zu den herkömmlichen magnetischen Transformatoren ein elektromechanisches System darstellt.

Beispielsweise beschreibt WO 2007/006298 A2 einen piezoelektrischen Transformator, der zur Erzeugung von Plasma verwendet werden kann.

Ferner zeigt Andrew Benwell et al: "Flashover Prevention of High Voltage Piezoelectric Transformers by Thin Film Encapsulation" piezoelektrische Transformatoren, die von einem Film aus dielektrischem Material eingeschlossen sind.

JP H09 181372 A zeigt einen weiteren piezoelektrischen Transformator. JP H06 52161 U zeigt einen piezoelektrischen Transformator, bei dem eine Isolationsschicht einen Ausgangsbereich teilweise bedeckt.

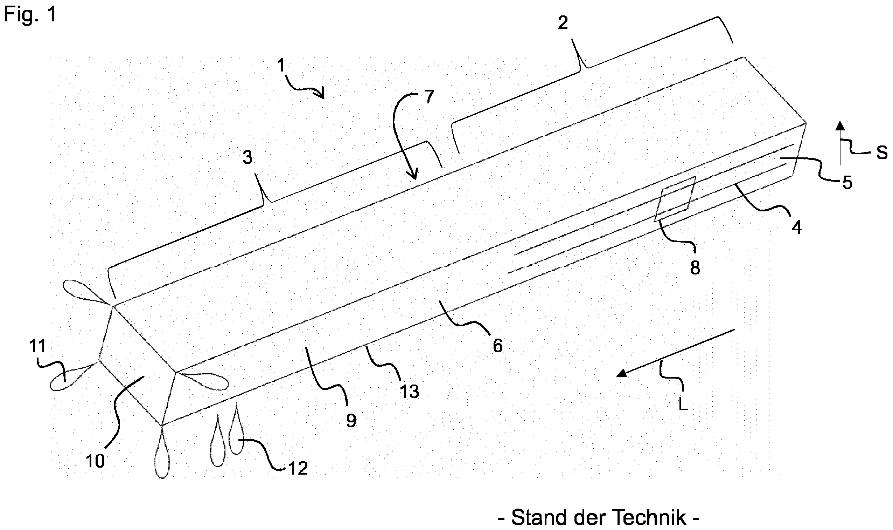

Figur 1 zeigt einen piezoelektrischen Transformator 1, der auch als Rosen-Transformator bekannt ist.

Der piezoelektrische Transformator 1 weist einen Eingangsbereich 2 und einen Ausgangsbereich 3 auf. Im Eingangsbereich 2 weist der piezoelektrische Transformator 1 Elektroden 4 auf, an die eine Wechselspannung angelegt werden kann. Die Elektroden 4 erstrecken sich in einer Längsrichtung L des piezoelektrischen Transformators 1. Die Elektroden 4 sind in einer Stapelrichtung S, die senkrecht zu der Längsrichtung L ist, abwechselnd mit einem piezoelektrischen Material 5 gestapelt. Das piezoelektrische Material 5 ist dabei in Stapelrichtung S polarisiert.

Die Elektroden 4 sind im Innern des piezoelektrischen Transformators 1 angeordnet und werden auch als Innenelektroden bezeichnet. Der piezoelektrische Transformator 1 weist eine erste Längsseite 6 und eine zweite Längsseite 7, die der ersten Längsseite 6 gegenüberliegt, auf. Auf der ersten Längsseite 6 ist eine erste Außenelektrode 8 angeordnet. Auf der zweiten Längsseite 7 ist eine zweite Außenelektrode (nicht gezeigt) angeordnet. Die innenliegenden Elektroden 4 sind in Stapelrichtung S abwechselnd entweder mit der ersten Außenelektrode 8 oder der zweiten Außenelektrode elektrisch kontaktiert.

Der Eingangsbereich 2 kann mit einer geringen Wechselspannung angesteuert werden, die zwischen den Elektroden 4 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei wesentlich von der Geometrie und dem mechanischen Aufbau des piezoelektrischen Transformators 1 abhängig.

Der Ausgangsbereich 3 weist piezoelektrisches Material 9 auf und ist frei von innenliegenden Elektroden. Das piezoelektrische Material 9 im Ausgangsbereich ist in Längsrichtung L polarisiert. Bei dem piezoelektrischen Material 9 des Ausgangsbereichs 3 kann es sich um das gleiche Material wie bei dem piezoelektrischen Material 5 des Eingangsbereichs 2 handeln, wobei sich die piezoelektrischen Materialien 5 und 9 in ihrer Polarisationsrichtung unterscheiden können.

Wird an die Elektroden 4 im Eingangsbereich 2 eine Wechselspannung angelegt, so bildet sich innerhalb des piezoelektrischen Materials 5, 9 eine mechanische Welle aus, die durch den piezoelektrischen Effekt im Ausgangsbereich 3 eine Ausgangsspannung erzeugt. Der Ausgangsbereich 3 weist eine ausgangsseitige Stirnseite 10 auf, die metallisiert ist und eine Ausgangselektrode bildet. Die im Ausgangsbereich 3 erzeugte elektrische Spannung liegt somit zwischen der metallisierten Stirnseite 10 und dem Ende der Elektroden 4 des Eingangsbereichs 2 an. An der ausgangsseitigen Stirnseite 10 liegt dabei eine Hochspannung an.

Auf diese Weise erzeugt der piezoelektrische Transformator 1 hohe elektrische Felder, die in der Lage sind, Gase durch elektrische Anregung zu ionisieren. Dabei werden Atome oder Moleküle des jeweiligen Gases ionisiert und bilden ein Plasma. Es kommt immer dann zu einer Ionisation, wenn die elektrische Feldstärke an der Oberfläche des piezoelektrischen Transformators 1 die Zündfeldstärke des Plasmas überschreitet. Als Zündfeldstärke eines Plasmas wird dabei die Feldstärke bezeichnet, die zur Ionisation der Atome oder Moleküle erforderlich ist.

Aus der Veröffentlichung Ito et al.: Discharge plasmas generated by piezoelectric transformers and their applications, Plasma Sources Sci. Technol. 15 (2006), ist bekannt, dass piezoelektrische Transformatoren zur Zündung eines Plasmas eingesetzt werden können. Dabei wird beschrieben, dass die Zündung des Plasmas sowohl an den seitlichen Längskanten als auch an den Kanten der ausgangsseitigen Stirnseite erfolgt.

In Figur 1 ist eine Zündung 11 von Plasma an der ausgangsseitigen Stirnseite und weitere Zündungen 12 von Plasma an den seitlichen Kanten 13 angedeutet.

Es wurde jedoch in der oben genannten Veröffentlichung nicht erkannt, dass die Zündungen an den seitlichen Kanten zu Rückkopplungen führen, bei denen hohe mechanische Spannungen in dem piezoelektrischen Material im Ausgangsbereich erzeugt werden, die im Betrieb des piezoelektrischen Transformators zu Rissen führen können, wodurch die Lebensdauer des piezoelektrischen Transformators verringert wird.

Die Aufgabe der vorliegenden Erfindung ist es dementsprechend, einen verbesserten piezoelektrischen Transformator bereitzustellen, der beispielsweise eine höhere Lebensdauer aufweist.

Die oben genannte Aufgabe wird durch einen piezoelektrischen Transformator gemäß dem vorliegenden Anspruch 1 gelöst.

Es wird ein piezoelektrischer Transformator vorgeschlagen, der in Längsrichtung in einen Eingangsbereich und einen Ausgangsbereich unterteilt ist, wobei im Eingangsbereich Elektroden und piezoelektrisches Material abwechselnd gestapelt sind und an die Elektroden im Eingangsbereich eine Wechselspannung anlegbar ist, wobei der Ausgangsbereich piezoelektrisches Material aufweist, das bei im Eingangsbereich angelegter Wechselspannung den Aufbau eines elektrischen Feldes bewirkt, wobei der piezoelektrische Transformator eine ausgangsseitige Stirnseite, die vom Eingangsbereich wegweist, und seitliche Kanten, die in Längsrichtung verlaufen, aufweist, und wobei der piezoelektrische Transformator dazu ausgestaltet ist, an der ausgangsseitigen Stirnseite Atome oder Moleküle zu ionisieren und dabei eine Ionisation von Atomen oder Molekülen an den seitlichen Kanten zu vermeiden.

Dadurch, dass eine Ionisation von Atomen oder Molekülen an den seitlichen Kanten vermieden wird, wird sichergestellt, dass es zu keiner unerwünschten Rückkopplung beim Zünden von Plasmen an den seitlichen Kanten kommt. Durch solche Rückkopplungen würden ansonsten mechanische Spannungsspitzen entstehen, die zu Rissen im piezoelektrischen Material und damit einer verkürzten Lebensdauer des piezoelektrischen Transformators führen würden. Das Auftreten solcher Risse wird durch die vorliegende Erfindung dementsprechend vermieden, sodass die Lebensdauer des piezoelektrischen Transformators erhöht wird.

Bei dem piezoelektrischen Transformator kann es sich um den oben beschriebenen Rosen-Transformator handeln, wobei zusätzlich Maßnahmen zur Vermeidung der Ionisation von Atomen oder Molekülen an den seitlichen Kanten vorgesehen sind. Alle strukturellen und funktionellen Merkmale, die im Zusammenhang mit dem Rosen-Transformator offenbart wurden, können auch bei dem erfindungsgemäßen piezoelektrischen Transformator vorliegen.

Insbesondere kann der Eingangsbereich Elektroden und piezoelektrisches Material aufweisen, die in einer Stapelrichtung abwechselnd gestapelt sind. Die Stapelrichtung ist dabei senkrecht zur Längsrichtung. Die Stapelrichtung ist ferner senkrecht zu der Flächennormale der ersten Längsseite 6, auf der die erste Außenelektrode 8 angeordnet ist.

Der Ausgangsbereich ist frei von innenliegenden Elektroden. Der Ausgangsbereich ist ein monolithischer Stack bestehend aus dem piezoelektrischen Material, wobei die ausgangsseitige Stirnseite metallisiert sein kann. Der Ausgangsbereich weist piezoelektrisches Material auf, das in Längsrichtung polarisiert ist.

Der Eingangsbereich wird auch als Anregungszone und der Ausgangsbereich als Hochspannungszone bezeichnet.

Der piezoelektrische Transformator hat eine im Wesentlichen quaderförmige Form. Die Längsrichtung ist definiert durch die Verbindung der am weitesten voneinander entfernt liegenden Außenflächen des piezoelektrischen Transformators, d.h. als Richtung entlang der längsten Kante des piezoelektrischen Transformators.

Zur gezielten Steuerung der Ionisation von Atomen oder Molekülen an der ausgangsseitigen Stirnseite unter Vermeidung von Ionisationen an den seitlichen Kanten ist es entscheidend, dass die elektrische Feldstärke an der Stirnseite ihr Maximum erreicht. Die seitlichen Kanten können dementsprechend so modifiziert werden, dass hier die Feldstärke des elektrischen Feldes gezielt reduziert wird und insbesondere das Auftreten von Spannungsspitzen vermieden wird. Insbesondere sollte die elektrische Feldstärke an den seitlichen Kanten unterhalb der Zündfeldstärke des Plasmas liegen, wenn die elektrische Feldstärke an der ausgangsseitigen Stirnseite die Zündfeldstärke erreicht.

Die seitlichen Kanten des piezoelektrischen Transformators können einen abgerundeten Bereich aufweisen. In diesem abgerundeten Bereich werden Spannungsspitzen vermieden, sodass es nicht zu einer Ionisation von Atomen oder Molekülen an den seitlichen Kanten kommt. Durch das Abrunden der Kanten wird die elektrische Feldstärke an der Oberfläche der seitlichen Kante reduziert.

Die Kanten können vor oder nach dem Sintern abgerundet werden.

Der abgerundete Bereich kann sich zumindest von der ausgangsseitigen Stirnseite bis zur Mitte des Ausgangsbereichs erstrecken. Beim Betrieb des piezoelektrischen Transformators liegt in diesem Bereich die größte elektrische Feldstärke vor. Dementsprechend ist es besonders in diesem Bereich wichtig, die Feldstärke an den Kanten zu reduzieren, um ein ungewünschtes Zünden eines Plasmas zu vermeiden. Vorzugsweise schließt sich der abgerundete Bereich unmittelbar an die ausgangsseitige Stirnseite an, da nahe der ausgangsseitigen Stirnseite die Gefahr von unerwünschten Ionisationen an den seitlichen Kanten besonders groß ist.

Der abgerundete Bereich kann sich über die gesamte Länge der seitlichen Kanten erstrecken. Bei bestimmten Verfahren zur Herstellung des abgerundeten Bereichs, beispielsweise beim Scheuern, ist es deutlich einfacher, die seitlichen Kanten auf ihrer gesamten Länge abzurunden. Eine Abrundung der seitlichen Kanten auch im Eingangsbereich beeinflusst die Funktionalität des piezoelektrischen Transformators nicht negativ.

Die seitlichen Kanten können im abgerundeten Bereich einen Radius zwischen 0,1 mm und 3 mm aufweisen. Würde der Radius kleiner als 0,1 mm gewählt werden, so wäre eine ausreichende Reduzierung der elektrischen Feldstärke an den seitlichen Kanten nicht mehr gewährleistet, da diese in diesem Fall quasi eckig wäre. Eine Abrundung mit einem Radius von 3 mm ist mehr als ausreichend, um die elektrische Feldstärke an den Kanten hinreichend zu reduzieren, so dass eine Abrundung mit einem noch größeren Radius nicht zu einer weiteren Verbesserung des Verhaltens des piezoelektrischen Transformators führen würde. Dementsprechend ist der Bereich für den Radius zwischen 0,1 und 3 mm optimal. Vorzugsweise kann der Radius ferner zwischen 0,2 bis 1,0 mm liegen.

Der abgerundete Bereich der seitlichen Kanten kann zum Beispiel mittels Scheuern, Schleifen oder Sandstrahlen abgerundet werden.

Als Scheuern bezeichnet man hier ein Verfahren, bei dem alle Kanten des piezoelektrischen Transformators im ungesinterten, grünen Zustand mittels losem Korn abgescheuert werden. Eine Vielzahl von piezoelektrischen Transformatoren kann dabei zusammen mit einem Scheuermittel in eine Trommel gebracht werden und dort aneinander gerieben werden, wodurch die Kanten abgerundet werden. Die Vorteile des Scheuerns liegen darin, dass dieses Verfahren sehr schnell und kostengünstig durchgeführt werden kann.

Durch das Scheuern werden auch die Kanten und Ecken der ausgangsseitigen Stirnseite abgerundet. Es entsteht dabei ein piezoelektrischer Transformator mit abgerundeter ausgangsseitiger Stirnseite, bei dem eine Ionisierung lediglich an den Ecken der Stirnseite erfolgt. Die Ecken der Stirnseite weisen in Folge der Abrundung eine vergrößerte Fläche auf, sodass ein aufgefächerter Plasmastrahl entsteht. Dieses kann für bestimmte Anwendungen vorteilhaft sein. Ist für die Anwendung eine Auffächerung des Plasmastrahls nicht gewünscht, so kann nach dem Scheuern ein Abschleifen der Stirnseite vorgenommen werden, wodurch die abgerundeten Kanten der Stirnseite wieder eckig werden.

Als Schleifen wird hier ein Verfahren bezeichnet, bei dem der piezoelektrische Transformator im gesinterten Zustand mit einer Schleifscheibe behandelt wird. Dabei kann der piezoelektrische Transformator sehr präzise behandelt werden. Insbesondere können die Kanten an der Stirnseite unbehandelt bleiben. Das Schleifen bietet eine hohe Designflexibilität. Beispielsweise kann mittels Schleifen der abgerundete Bereich derart ausgestaltet werden, dass er einen auslaufenden Radius aufweist. Der Radius des abgerundeten Bereichs kann an der ausgangsseitigen Stirnseite maximal sein und zur Eingangsseite hin abnehmen. Schleifen ermöglicht es auch, die Stirnseite in eine gewünschte Form zu bringen. Die Stirnseite kann beispielsweise halbkugelförmig oder pyramidenartig spitz zulaufend ausgestaltet werden. Je nach Ausgestaltung der Stirnseite ergibt sich eine andere Form des erzeugbaren Plasmastrahls.

Ein weiterer Vorteil des Schleifens ist es, dass dieses Verfahren zu einer sehr glatten Oberfläche führt, so dass es nicht zu lokalen Feldüberhöhungen an Unebenheiten kommen kann.

Beim Sandstrahlen werden die seitlichen Kanten unter Druckluft mit losem Korn bestrahlt. Auf diese Weise wird Material von den seitlichen Kanten abgetragen. Sandstrahlen kann im gesinterten Zustand des piezoelektrischen Transformators vorgenommen werden. Die Bereiche des piezoelektrischen Transformators, die beim Sandstrahlen unbehandelt bleiben sollen, können während des Sandstrahlens abgedeckt, beispielsweise abgeklebt, werden.

Werden die seitlichen Kanten abgerundet, so wird dabei die Masse des piezoelektrischen Transformators nur in so geringem Maße verändert, dass sich das Schwingverhalten des piezoelektrischen Transformators nicht ändert.

Der Ausgangsbereich ist zumindest teilweise mit einer Isolationsschicht beschichtet. Die Isolationsschicht reduziert die elektrische Feldstärke an der Oberfläche der von ihr bedeckten Bereiche. Die Isolationsschicht kann insbesondere die seitlichen Kanten zumindest teilweise bedecken.

Durch die Isolationsschicht kann auf diese Weise sichergestellt werden, dass die elektrische Feldstärke an der Oberfläche der seitlichen Kanten nicht zu groß wird und so kann eine Ionisierung von Atomen und/oder Molekülen an den seitlichen Kanten verhindert werden. Das Aufbringen der Isolationsschicht kann mit dem Abrunden der seitlichen Kanten kombiniert werden, um durch die Kombination dieser beiden Maßnahmen eine unerwünschte Ionisation an den seitlichen Kanten zu vermeiden.

Die Isolationsschicht kann eine Länge haben die im Bereich von 15% bis 45% der Gesamtlänge des piezoelektrischen Transformators liegt, vorzugsweise im Bereich von 20% bis 30% der Gesamtlänge.

Die Isolationsschicht kann einen Schrumpfschlauch aufweisen. Der Schrumpfschlauch kann insbesondere mit einem Schmelzkleber an seiner Innenseite beschichtet sein. Auf diese Weise kann verhindert werden, dass der Schrumpfschlauch sich durch Vibrationen des piezoelektrischen Transformators im Betrieb von diesem lösen kann und von dem Ausgangsbereich abrutscht.

Der Schrumpfschlauch kann mit der ausgangsseitigen Stirnseite bündig abschließen oder über die Stirnseite hinaus stehen. Alternativ kann auch ein Endbereich des Ausgangsbereichs, der sich an die ausgangsseitige Stirnseite anschließt, frei von dem Schrumpfschlauch bleiben.

Ist der Schrumpfschlauch leicht überstehend, so kommt es zu einer Bündelung des Plasmas. Dieses ist für Anwendungen vorteilhaft, die die Wirkung des Plasmas nutzen, um zum Beispiel Oberflächen zu aktivieren. Endet der Schrumpfschlauch bündig mit dem piezoelektrischen Transformator oder lässt er einen kleinen Endbereich der seitlichen Kanten, der eine Länge von nicht mehr als 2 mm hat, offen, so wird das Plasma nicht gerichtet. Dadurch entsteht ein Betrieb in einem sauerstoffhaltigen Arbeitsgas mehr Ozon, was für medizinische Anwendungen vorteilhaft sein kann. Dementsprechend sollte die Länge des Schrumpfschlauchs an dem gewünschten Einsatzzweck angepasst werden.

Die Isolationsschicht kann zumindest eines ausgewählt aus Silikon, einem ausgehärteten Polymer oder einem Lack aufweisen. Diese Materialien können in flüssiger Form als Isolationsschicht aufgebracht werden. Dazu eignet sich ein flüssiger Verguss, das Aufbringen mit einer Form oder Lackieren.

Entlang der seitlichen Kanten sollte die Isolationsschicht eine ausreichende Dicke haben. Diese kann beim Aufbringen der Isolationsschicht in flüssiger Form durch eine Einstellung der Viskosität oder durch mehrfaches Aufbringen sichergestellt werden.

Die Stirnseite kann frei von der Isolationsschicht sein. Dieses ist wichtig, da eine Ionisierung der Atome oder Moleküle an der Stirnseite gewünscht ist und nicht durch die Isolationsschicht behindert werden sollte.

Die Isolationsschicht kann eine Dicke im Bereich von 0,1 mm bis 3 mm aufweisen, wobei die Dicke vorzugsweise zwischen 0,2 und 1,0 mm liegt. Durch die Isolationsschicht wird eine zusätzliche Masse zu dem piezoelektrischen Transformator zugefügt, wodurch sich sein Schwingungsverhalten ändert. Dementsprechend sollte die Isolationsschicht möglichst dünn gewählt werden. Sie muss jedoch dick genug sein, um die Feldstärke an der Oberfläche der seitlichen Kanten unter die Zündfeldstärke des Plasmas zu reduzieren. Diese Anforderungen werden Isolationsschichten mit einer Dicke zwischen 0,1 mm und 3 mm gerecht.

Der piezoelektrische Transformator kann zur Erzeugung von kalten Atmosphären-Plasma dienen.

Die Atmosphärendruck-Plasmen lassen sich in sogenannte kalte, nichtthermische Plasmen mit einer Gastemperatur von typischerweise kleiner als 100 °C sowie thermische Plasmen mit höheren Gastemperaturen unterscheiden. Die vorliegende Erfindung befasst sich mit kalten, nichtthermischen Plasmen, die den Vorteil haben, dass die Gastemperatur in der Größenordnung der Zimmertemperatur oder nur geringfügig darüber liegt, sodass auch eine längere Verweildauer des Plasmas an einem zu behandelnden Substrat möglich ist und auch empfindliche Substrate, zum Beispiel dünne Polymerfolien, länger mit diesem Plasma behandelt werden können, ohne dass die Oberfläche des Substrats oder das Substrat selbst beschädigt wird.

Bei dem piezoelektrischen Transformator kann es sich um einen Rosen-Transformator handeln.

Ferner weist die ausgangsseitige Stirnseite abgerundete Kanten und abgerundete Ecken auf. Die ausgangsseitige Stirnseite kann zur Erzeugung eines aufgefächerten Plasmastrahls geeignet sein.

Ferner betrifft die vorliegende Erfindung eine Vorrichtung zur Erzeugung von Atmosphärendruck-Plasma, die den oben beschriebenen piezoelektrischen Transformator aufweist, der in einem gasgefüllten Volumen angeordnet ist. Der piezoelektrische Transformator wird dementsprechend zur Ionisierung des Gases verwendet und erzeugt auf diese Weise das Plasma. Eine solche Vorrichtung kann insbesondere zum Aktivieren oder anderweitigem Bearbeiten von Oberflächen und für medizinische Anwendungen eingesetzt werden.

Im Folgenden wird die vorliegende Erfindung anhand von Figuren weiter erläutert.
- Figur 1: zeigt einen im Stand der Technik bekannten piezoelektrischen Transformator.
- Figur 2: zeigt einen piezoelektrischen Transformator.
- Figur 3: zeigt einen piezoelektrischen Transformator gemäß einem Ausführungsbeispiel der vorliegenden Erfindung.
- Figur 4: zeigt einen Querschnitt durch den in Figur 3 gezeigten piezoelektrischen Transformator.

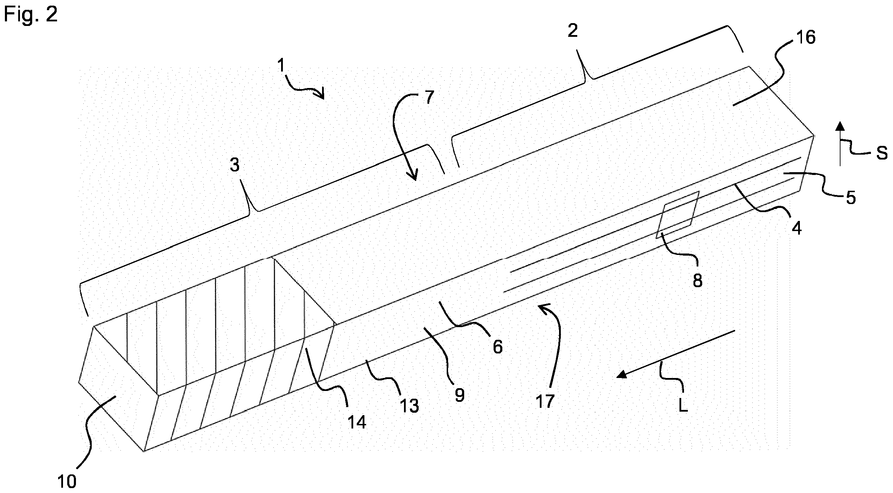

Figur 2 zeigt einen piezoelektrischen Transformator 1. Der piezoelektrische Transformator 1 weist neben der ersten und der zweiten Längsseite 6, 7 ferner eine dritte Längsseite 16 und eine vierte Längsseite 17 auf. Jede der Längsseiten 6, 7, 16, 17 erstreckt sich in Längsrichtung L. Jede der Längsseiten 6, 7, 16, 17 ist ferner senkrecht zu der ausgangsseitigen Stirnseite 10.

Etwa ein Viertel der Gesamtlänge des piezoelektrischen Transformators 1 ist von einer Isolationsschicht 14 bedeckt. Die Isolationsschicht 14 ist dabei auf den Längsseiten 6, 7, 16, 17 aufgebracht. Die ausgangsseitige Stirnseite 10 ist frei von der Isolationsschicht.

Das Material der Isolationsschicht 14 ist dabei so gewählt, dass an der nach außen weisenden Seite der Isolationsschicht 14, eine elektrische Feldstärke, die im Innern der Isolationsschicht 14 vorliegt, deutlich reduziert ist. Die Isolationsschicht 14 isoliert somit das elektrische Feld. Dementsprechend wird die elektrische Feldstärke in den Bereichen der seitlichen Kanten 13, die von der Isolationsschicht 14 bedeckt sind, deutlich verringert.

Bei der Isolationsschicht 14 kann es sich entweder um einen Schrumpfschlauch oder um eine Schicht handeln, die aus Silikon, einem Lack oder einem ausgehärteten Polymer besteht. Die Isolationsschicht 14 erstreckt sich von der ausgangsseitigen Stirnseite 10 bis zu einer Länge von einem Viertel des piezoelektrischen Transformators.

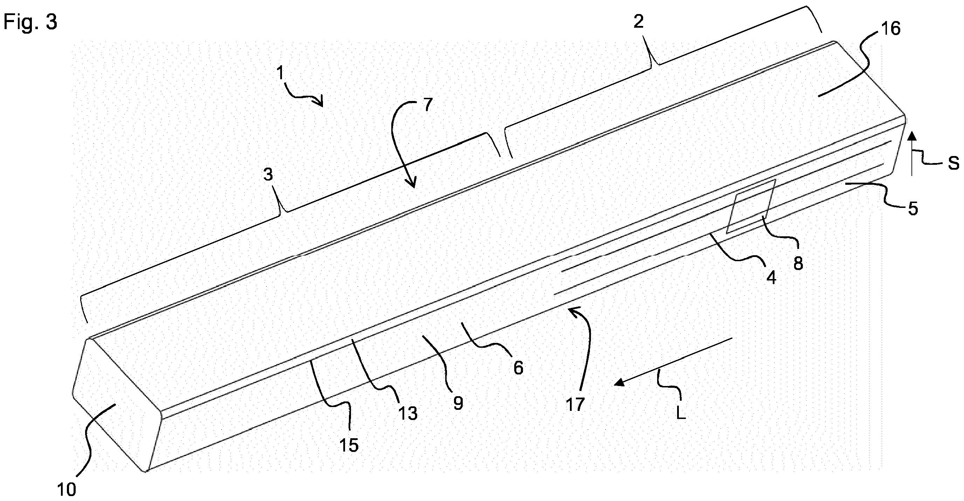

Figur 3 zeigt ein Ausführungsbeispiel eines piezoelektrischen Transformators 1. Die seitlichen Kanten 13 des piezoelektrischen Transformators 1 weisen hier einen abgerundeten Bereich 15 auf. In dem abgerundeten Bereich 15 sind die seitlichen Kanten 13 nicht wie in den übrigen Bereichen eckig, sondern abgerundet. Bei dem in Figur 3 gezeigten Ausführungsbeispiel erstreckt sich der abgerundete Bereich 15 über die gesamte Länge der seitlichen Kanten 13.

In dem abgerundeten Bereich 15 ist die elektrische Feldstärke an den seitlichen Kanten 13 über eine größere Fläche verteilt, so dass das Auftreten von Spannungsspitzen vermieden wird und die maximal erreichte elektrische Feldstärke in dem Bereich der seitlichen Kanten 13 reduziert ist. Insbesondere wird die elektrische Feldstärke an den seitlichen Kanten 13 so stark reduziert, dass sie geringer ist als die Feldstärke, die zur Ionisation von Atomen oder Molekülen erforderlich ist.

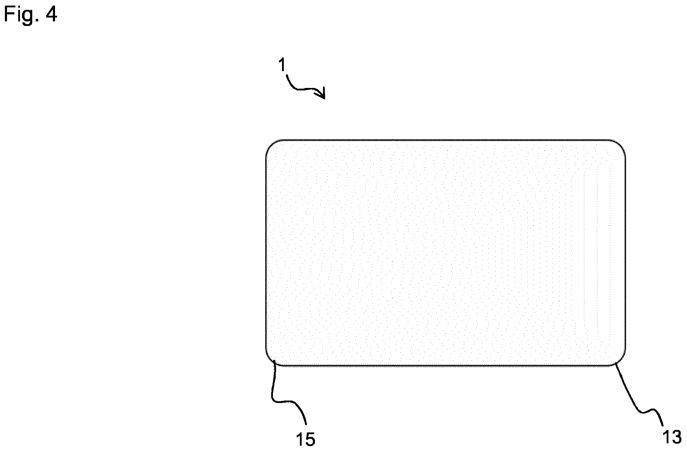

Figur 4 zeigt einen Querschnitt senkrecht zur Längsrichtung L durch den in Figur 3 gezeigten piezoelektrischen Transformator 1. Hierbei ist zu erkennen, dass der piezoelektrische Transformator 1 gerundete seitliche Kanten 13 aufweist.

Durch die Länge des piezoelektrischen Transformators 1 wird im Wesentlichen seine Arbeitsfrequenz bestimmt. Wird eine Länge von 70 mm gewählt, so ergibt sich eine Arbeitsfrequenz von 50 kHz. Diese Arbeitsfrequenz ist insbesondere zur Aktivierung beziehungsweise Bearbeitung von Oberflächen geeignet. Für medizinische Anwendungen kann eine Arbeitsfrequenz von 100 kHz vorteilhaft sein. Dementsprechend wird hier eine Länge des piezoelektrischen Transformators 1 von 35 mm gewählt.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Längsseite
- 7: zweite Längsseite
- 8: erste Außenelektrode
- 9: piezoelektrisches Material
- 10: ausgangsseitige Stirnseite
- 11: Zündung von Plasma an der ausgangsseitigen Stirnseite
- 12: Zündung von Plasma an seitlichen Kanten
- 13: seitliche Kante
- 14: Isolationsschicht
- 15: abgerundeter Bereich
- 16: dritte Längsseite
- 17: vierte Längsseite
- L: Längsrichtung
- S: Stapelrichtung

## Patentansprüche

1. Piezoelektrischer Transformator (1),
der in Längsrichtung (L) in einen Eingangsbereich (2) und einen Ausgangsbereich (3) unterteilt ist,
wobei im Eingangsbereich (2) Elektroden (4) und piezoelektrisches Material (5) abwechselnd gestapelt sind,
wobei der Ausgangsbereich (3) piezoelektrisches Material (9) aufweist und derart konzipiert ist, dass die an die Elektroden (4) im Eingangsbereich (2) angelegte Wechselspannung den Aufbau eines elektrischen Feldes bewirkt,
wobei der piezoelektrische Transformator (1) eine ausgangsseitige Stirnseite (10), die vom Eingangsbereich (2) wegweist, und seitliche Kanten (13), die in Längsrichtung (L) verlaufen, aufweist,
und
wobei der piezoelektrische Transformator (1) dazu ausgestaltet ist, an der ausgangsseitigen Stirnseite (10) Atome oder Moleküle zu ionisieren,
wobei die Ecken und alle Kanten der ausgangseitigen Stirnseite (10) abgerundet sind und **dadurch gekennzeichnet, dass** der Ausgangsbereich (3) zumindest teilweise auf allen Längsseiten (6, 7, 16, 17) mit einer Isolationsschicht (14) beschichtet ist.

2. Piezoelektrischer Transformator (1) gemäß Anspruch 1, wobei die seitlichen Kanten (13) einen abgerundeten Bereich (15) aufweisen.

3. Piezoelektrischer Transformator (1) gemäß Anspruch 2, wobei der abgerundete Bereich (15) sich zumindest von der ausgangsseitigen Stirnseite (10) bis zur Mitte des Ausgangsbereichs (3) erstreckt.

4. Piezoelektrischer Transformator (1) gemäß einem der Ansprüche 2 oder 3,
wobei der abgerundete Bereich (15) sich über die gesamte Länge der seitlichen Kanten (13) erstreckt.

5. Piezoelektrischer Transformator (1) gemäß einem der Ansprüche 2 bis 4,
wobei die seitlichen Kanten (13) in dem abgerundeten Bereich (15) einem Radius zwischen 0,1 mm und 3 mm aufweisen.

6. Piezoelektrischer Transformator (1) gemäß einem der Ansprüche 2 bis 5,
wobei der abgerundete Bereich (15) mittels Scheuern, Schleifen oder Sandstrahlen abgerundet ist.

7. Piezoelektrischer Transformator (1) gemäß einem der vorherigen Ansprüche,
wobei die Isolationsschicht (14) einen Schrumpfschlauch aufweist.

8. Piezoelektrischer Transformator (1) gemäß Anspruch 7, wobei der Schrumpfschlauch mit der ausgangsseitigen Stirnseite (10) bündig abschließt oder über die Stirnseite (10) hinaussteht.

9. Piezoelektrischer Transformator (1) gemäß einem der vorherigen Ansprüche,
wobei die Isolationsschicht (14) zumindest eines ausgewählt aus Silikon, einem ausgehärteten Polymer oder einem Lack aufweist.

10. Piezoelektrischer Transformator (1) gemäß einem der vorherigen Ansprüche,
wobei die Stirnseite (10) frei von der Isolationsschicht (14) ist.

11. Piezoelektrischer Transformator (1) gemäß einem der vorherigen Ansprüche,
wobei die Isolationsschicht (14) eine Dicke im Bereich von 0,1 mm bis 3 mm aufweist.

12. Piezoelektrischer Transformator (1) gemäß einem der vorherigen Ansprüche, der zur Erzeugung von kaltem Atmosphären-Plasma dient.

13. Piezoelektrischer Transformator (1) gemäß einem der vorherigen Ansprüche,
wobei es sich um einen Rosen-Transformator (1) handelt.

14. Piezoelektrischer Transformator (1) gemäß einem der vorherigen Ansprüche,
bei dem die ausgangsseitige Stirnseite (10) metallisiert ist.

15. Piezoelektrischer Transformator (1) gemäß einem der vorherigen Ansprüche,
bei dem die ausgangsseitige Stirnseite (10) nicht metallisiert ist.

16. Piezoelektrischer Transformator (1) gemäß einem der vorherigen Ansprüche,
wobei die Isolationsschicht (14) durch einen flüssigen Verguss aufgebracht ist.

17. Vorrichtung zur Erzeugung von Atmosphärendruck-Plasma, die einen piezoelektrischen Transformator (1) gemäß einem der vorherigen Ansprüche aufweist, der in einem gasgefüllten Volumen angeordnet ist.

## Claims

1. Piezoelectric transformer (1),
which is subdivided in the longitudinal direction (L) into an input region (2) and an output region (3), wherein electrodes (4) and piezoelectric material (5) are alternately stacked in the input region (2), wherein the output region (3) has piezoelectric material (9) and is designed such that the AC voltage applied to the electrodes (4) in the input region (2) brings about build up of an electrical field,
wherein the piezoelectric transformer (1) has an end face (10) on the output side which points away from the input region (2), and lateral edges (13) which extend in the longitudinal direction (L),
and
wherein the piezoelectric transformer (1) is designed to ionize atoms or molecules at the output-side end face (10),
wherein the corners and all the edges of the output-side end face (10) are rounded and **characterized in that** the output region (3) is coated at least in part on all the longitudinal sides (6, 7, 16, 17) with an insulation layer (14).

2. Piezoelectric transformer (1) according to Claim 1,
wherein the lateral edges (13) have a rounded region (15) .

3. Piezoelectric transformer (1) according to Claim 2,
wherein the rounded region (15) extends at least from the output-side end face (10) to the middle of the output region (3).

4. Piezoelectric transformer (1) according to one of Claims 2 or 3,
wherein the rounded region (15) extends over the entire length of the lateral edges (13).

5. Piezoelectric transformer (1) according to one of Claims 2 to 4,
wherein the lateral edges (13) have a radius of between 0.1 mm and 3 mm in the rounded region (15).

6. Piezoelectric transformer (1) according to one of Claims 2 to 5,
wherein the rounded region (15) is rounded by means of tumbling, grinding or sand-blasting.

7. Piezoelectric transformer (1) according to one of the preceding claims,
wherein the insulation layer (14) has a heat-shrinkable sleeve.

8. Piezoelectric transformer (1) according to Claim 7,
wherein the heat-shrinkable sleeve terminates flush with the output-side end face (10) or protrudes beyond the end face (10).

9. Piezoelectric transformer (1) according to one of the preceding claims,
wherein the insulation layer (14) includes at least one of silicone, a cured polymer or a varnish.

10. Piezoelectric transformer (1) according to one of the preceding claims,
wherein the end face (10) is free of the insulation layer (14).

11. Piezoelectric transformer (1) according to one of the preceding claims,
wherein the insulation layer (14) has a thickness in the range from 0.1 mm to 3 mm.

12. Piezoelectric transformer (1) according to one of the preceding claims,
which serves in producing cold atmospheric plasma.

13. Piezoelectric transformer (1) according to one of the preceding claims,
wherein the transformer is a Rosen transformer (1).

14. Piezoelectric transformer (1) according to one of the preceding claims,
in which the output-side end face (10) is metallized.

15. Piezoelectric transformer (1) according to one of the preceding claims,
in which the output-side end face (10) is not metallized.

16. Piezoelectric transformer (1) according to one of the preceding claims,
wherein the insulation layer (14) is applied by liquid potting.

17. Device for producing atmospheric pressure plasma, which has a piezoelectric transformer (1) according to one of the preceding claims which is arranged in a gas-filled volume.

## Revendications

1. Transformateur piézoélectrique (1),
qui est subdivisé dans la direction longitudinale (L) en une zone d'entrée (2) et une zone de sortie (3),
des électrodes (4) et un matériau piézoélectrique (5) étant empilés en alternance dans la zone d'entrée (2),
la zone de sortie (3) présentant un matériau piézoélectrique (9) et étant conçue de manière telle que la tension alternative appliquée aux électrodes (4) dans la zone d'entrée (2) provoque la création d'un champ électrique,
le transformateur piézoélectrique (1) présentant une face avant côté sortie (10) qui est à l'opposé de la zone d'entrée (2) et des bords latéraux (13) qui s'étendent dans la direction longitudinale (L),
et
le transformateur piézoélectrique (1) étant conçu pour ioniser des atomes ou molécules sur la face avant côté sortie (10),
les angles et tous les bords de la face avant côté sortie (10) étant arrondis et **caractérisé en ce que** la zone de sortie (3) est revêtue au moins en partie sur tous les côtés longitudinaux (6, 7, 16, 17) par une couche d'isolation (14) .

2. Transformateur piézoélectrique (1) selon la revendication 1,
les bords latéraux (13) présentant une zone arrondie (15) .

3. Transformateur piézoélectrique (1) selon la revendication 2,
la zone arrondie (15) s'étendant au moins depuis la face avant côté sortie (10) jusqu'au centre de la zone de sortie (3) .

4. Transformateur piézoélectrique (1) selon l'une quelconque des revendications 2 ou 3,
la zone arrondie (15) s'étendant sur toute la longueur des bords latéraux (13).

5. Transformateur piézoélectrique (1) selon l'une quelconque des revendications 2 à 4,
les bords latéraux (13) présentant, dans la zone arrondie (15), un rayon entre 0,1 mm et 3 mm.

6. Transformateur piézoélectrique (1) selon l'une quelconque des revendications 2 à 5,
la zone arrondie (15) étant arrondie par ponçage, meulage ou sablage.

7. Transformateur piézoélectrique (1) selon l'une quelconque des revendications précédentes,
la couche d'isolation (14) présentant une gaine rétractable.

8. Transformateur piézoélectrique (1) selon la revendication 7,
la gaine rétractable se terminant à fleur de la face avant côté sortie (10) ou dépassant la face avant (10).

9. Transformateur piézoélectrique (1) selon l'une quelconque des revendications précédentes,
la couche d'isolation (14) présentant au moins l'un choisi parmi la silicone, un polymère durci ou un vernis.

10. Transformateur piézoélectrique (1) selon l'une quelconque des revendications précédentes,
la face avant (10) étant exempte de la couche d'isolation (14).

11. Transformateur piézoélectrique (1) selon l'une quelconque des revendications précédentes,
la couche d'isolation (14) présentant une épaisseur dans la plage de 0,1 mm à 3 mm.

12. Transformateur piézoélectrique (1) selon l'une quelconque des revendications précédentes,
qui sert à la génération d'un plasma atmosphérique froid.

13. Transformateur piézoélectrique (1) selon l'une quelconque des revendications précédentes,
où il s'agit d'un transformateur de Rosen (1).

14. Transformateur piézoélectrique (1) selon l'une quelconque des revendications précédentes,
dans lequel la face avant côté sortie (10) est métallisée.

15. Transformateur piézoélectrique (1) selon l'une quelconque des revendications précédentes,
dans lequel la face avant côté sortie (10) n'est pas métallisée.

16. Transformateur piézoélectrique (1) selon l'une quelconque des revendications précédentes,
la couche d'isolation (14) étant appliquée par une encapsulation liquide.

17. Dispositif pour créer un plasma à pression atmosphérique, qui présente un transformateur piézoélectrique (1) selon l'une quelconque des revendications précédentes qui est disposé dans un volume rempli de gaz.
